# EUROPEAN PATENT APPLICATION

(11) **EP 3 968 362 A1**
(43) Date of publication of application: **16.03.2022**
(21) Application number: 21170369.9
(22) Date of filing: 26.04.2021
(51) Int. Cl.: H01L 21/48, H01L 23/498, H05K 1/03, H05K 3/46

(54) **MULTI-LAYER SUBSTRATE STRUCTURE WHICH CAN BE PEELED OFF PRECISELY AND A METHOD FOR MANUFACTURING THE SAME**

(30) Priority: 11.09.2020 TW 109131422
(71) Applicant: Princo Corp., Hsinchu City 30077 (TW)
(72) Inventor: Chiu, Pei-liang, 30077 Hsinchu City (TW); Chu, Yi-lin, 30077 Hsinchu City (TW)
(74) Representative: Petraz, Gilberto Luigi

(57) **Abstract**

A multi-layer substrate structure which can be peeled off precisely includes: a substrate (500); a first flexible dielectric layer (502) formed on the substrate (500); a peel-off layer (504) formed on the first flexible dielectric layer (502); and a unit (506) to be peeled off formed on the peel-off layer (504); wherein an adhesive force between the peel-off layer (504) and the first flexible dielectric layer (502) is smaller than an adhesive force between the first flexible dielectric layer (502) and the substrate (500), and the substrate (500), the first flexible dielectric layer (502), the peel-off layer (504), and the unit (506) to be peeled off together form the multi-layer substrate structure. A method for manufacturing a multi-layer substrate structure which can be peeled off precisely is also provided.

## Description

### TECHNICAL FIELD OF DISCLOSURE

The present disclosure relates to the technical field of multi-layer substrates, and more particularly to a multi-layer substrate structure which can be peeled off precisely and a method for manufacturing the same.

### BACKGROUND OF DISCLOSURE

In the prior art, a multi-layer substrate can be formed on a substrate. The substrate can be a circuit board or a glass board. The multi-layer substrate includes a flexible dielectric material or is a multi-layer substrate of which a main body is a flexible dielectric material. The multi-layer substrate includes a plurality of metal layers and a plurality of dielectric layers which are alternately stacked. When a dielectric layer or the multi-layer substrate on the substrate is required to be removed, an etching method is used conventionally. The etching method can be classified into a wet etching method and a dry etching method. In the wet etching method, the dielectric layer or the multi-layer substrate on the substrate is soaked in an etching solution. The dry etching method can be an ion etching method, for example, a reactive ion etching method, a chemical dry etching and so on. However, an uncontrolled situation occurs regardless of the dry etching method or the wet etching method. This leads to uncertainty of removing the dielectric layer or the multi-layer substrate on the substrate.

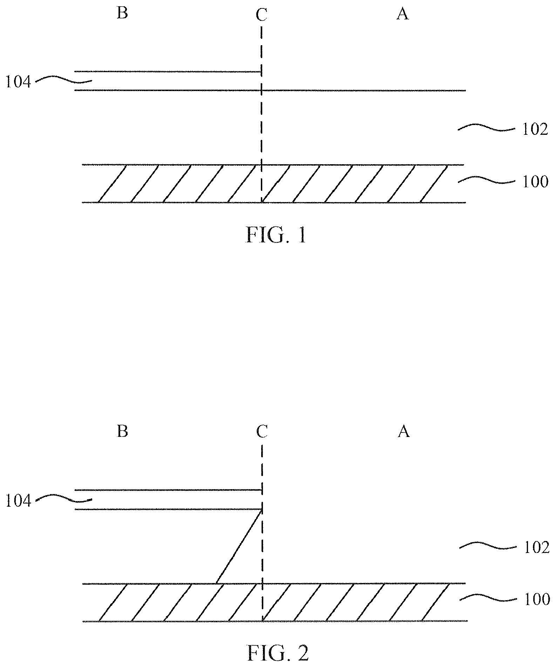

As shown in FIG. 1, a flexible dielectric layer 102 is formed on a substrate 100. Assuming that the flexible dielectric layer 102 in a right portion A is required to be removed. A dashed line C is a dividing line between the right portion A and a left portion B (a reserved portion). First, an etching resistant material 104 is coated on the flexible dielectric layer 102 in the left portion B to protect the flexible dielectric layer 102 in the left portion B. Then, the flexible dielectric layer 102 in the right portion A is removed by an etching solution or a dry etching method.

As shown in FIG. 2, an etching process is non-directional. As long as a portion of the dielectric layer 102 contacts the wet etching solution or charged gas ions in the dry etching method, the portion of the dielectric layer 102 reacts to the wet etching solution or the charged gas ions in the dry etching method. When a specific etching depth is reached, the dielectric layer 102 is etched down and toward the left. This causes the dielectric layer 102 in the left portion B is also removed.

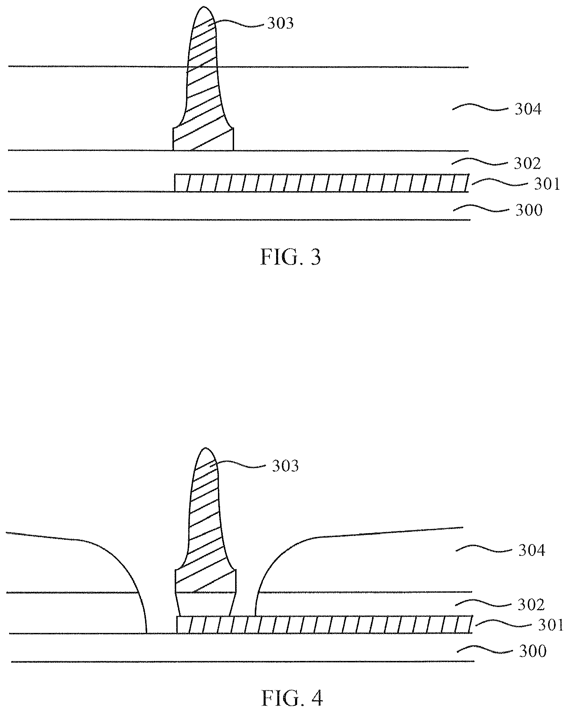

In another example, as shown in FIG. 3, a metal layer 301 is formed on a substrate 300. A first flexible dielectric layer 302 is formed on the substrate 300 and the metal layer 301. The metal layer 301 is positioned between the substrate 300 and the first flexible dielectric layer 302. A second flexible dielectric layer 304 is formed on the first flexible dielectric layer 302. A metal probe 303 is formed in the second flexible dielectric layer 304. Most of the metal probe 303 is covered by the second flexible dielectric layer 304. The second flexible dielectric layer 304 only exposes a portion of the metal probe 303. When the second flexible dielectric layer 304 is required to be removed to expose the metal probe 303, it is necessary to reserve the first flexible dielectric layer 302 to prevent a short circuit from occurring between the metal layer 301 and the metal probe 303.

As shown in FIG. 4, when charged gas ions in a dry etching method contact the second flexible dielectric layer 304 to remove the second flexible dielectric layer 304. Heat which is produced when the charged gas ions impact the metal probe 303 causes a temperature of the metal probe is increased in an etching process. Accordingly, an etching rate of a portion of the second flexible dielectric layer 304 adjacent to the metal probe 303 is accelerated, so that the first flexible dielectric layer 302 is also removed. A risk that a short circuit occurs between the metal probe 303 and the metal layer 301 is increased.

Therefore, there is a need to solve the above-mentioned problems in the prior art.

### SUMMARY OF DISCLOSURE

An objective of the present disclosure is to provide a multi-layer substrate structure which can be peeled off precisely and a method for manufacturing the same.

The multi-layer substrate structure which can be peeled off precisely of the present disclosure includes: a substrate; a first flexible dielectric layer formed on the substrate; a peel-off layer formed on the first flexible dielectric layer; and a unit to be peeled off formed on the peel-off layer; wherein an adhesive force between the peel-off layer and the first flexible dielectric layer is smaller than an adhesive force between the first flexible dielectric layer and the substrate, and the substrate, the first flexible dielectric layer, the peel-off layer, and the unit to be peeled off together form the multi-layer substrate structure.

The method for manufacturing the multi-layer substrate structure which can be peeled off precisely of the present disclosure includes: providing a substrate; forming a first flexible dielectric layer on the substrate; forming a peel-off layer on the first flexible dielectric layer, wherein an adhesive force between the peel-off layer and the first flexible dielectric layer is smaller than an adhesive force between the first flexible dielectric layer and the substrate; and forming a unit to be peeled off on the peel-off layer.

In the multi-layer substrate structure which can be peeled off precisely and the method for manufacturing the same, since the adhesive force between the peel-off layer and the first flexible dielectric layer is smaller than the adhesive force between the first flexible dielectric layer and the substrate, the at least one film layer on the peel-off layer can be totally or partially and precisely removed by peeling off the peel-off layer.

### BRIEF DESCRIPTION OF DRAWINGS

FIG. 1 illustrates that a flexible dielectric layer in a right portion is not removed in the prior art.
FIG. 2 illustrates that the flexible dielectric layer in the right portion is removed in the prior art.
FIG. 3 illustrates that a second flexible dielectric layer is not removed in the prior art.
FIG. 4 illustrates that the second flexible dielectric layer is removed in the prior art.
FIG. 5 illustrates a section diagram of a multi-layer substrate structure which can be peeled off precisely in accordance with an embodiment of the present disclosure.
FIG. 6 illustrates a flow chart of a method for manufacturing a multi-layer substrate structure which can be peeled off precisely in accordance with an embodiment of the present disclosure.
FIG. 7A to FIG. 7E illustrate a detailed flow chart of the method for manufacturing the multi-layer substrate structure in FIG. 5.

### DETAILED DESCRIPTION OF DISCLOSURE

To make the objectives, technical schemes, and technical effects of the present disclosure clearer and more definitely, the present disclosure will be described in detail below by using embodiments in conjunction with the appending drawings. It should be understood that the specific embodiments described herein are merely for explaining the present disclosure, and as used herein, the term "embodiment" refers to an instance, an example, or an illustration but is not intended to limit the present disclosure. In addition, the articles "a" and "an" as used in the specification and the appended claims should generally be construed to mean "one or more" unless specified otherwise or clear from the context to be directed to a singular form. Also, in the appending drawings, the components having similar or the same structure or function are indicated by the same reference number.

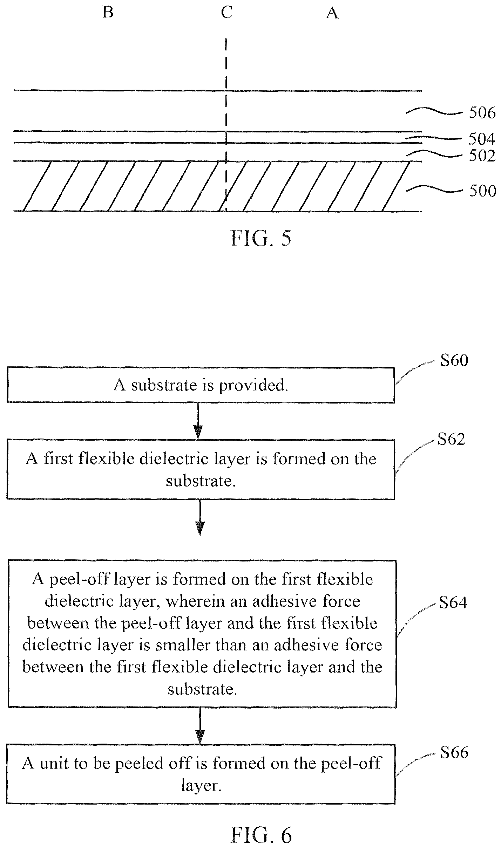

Please refer to FIG. 5. FIG. 5 illustrates a section diagram of a multi-layer substrate structure which can be peeled off precisely in accordance with an embodiment of the present disclosure.

As shown in FIG. 5, the multi-layer substrate structure includes a substrate 500, a first flexible dielectric layer 502, a peel-off layer 504, and a unit 506 to be peeled off. The substrate 500, the first flexible dielectric layer 502, the peel-off layer 504, and the unit 506 to be peeled off together form the multi-layer substrate structure.

The substrate 500 can be a single-layer substrate or a multi-layer substrate. The substrate 500 can be selected from the group consisting of a circuit board, a glass substrate, and a ceramic substrate. A material of the substrate 500 is an organic material or an inorganic material.

The substrate 500 includes at least one dielectric layer and at least one metal layer which are alternately stacked. The at least one metal layer can be selected from the group consisting of a metal wiring layer (i.e., a signal layer), a power supply layer, and a ground layer. A material of the at least one dielectric layer of the substrate can be polyimide (PI).

The first flexible dielectric layer 502 is formed on the substrate 500. A material of the first flexible dielectric layer 502 can be polyimide.

The peel-off layer 504 is formed on the first flexible dielectric layer 502. An adhesive force between the peel-off layer 504 and the first flexible dielectric layer 502 is smaller than an adhesive force between the first flexible dielectric layer 502 and the substrate 500, so that at least one film layer on the peel-off layer 504 can be easily removed by tearing the peel-off layer 504. In detail, the at least one film layer on the peel-off layer 504 can be totally or partially and precisely removed by peeling off the peel-off layer 504.

The unit 506 to be peeled off is formed on the peel-off layer 504. A right portion A in the unit 506 to be peeled off is a portion required to be removed. A left portion B in the unit 506 to be peeled off is a portion required to be reserved. A dashed line C is a dividing line between the right portion A and the left portion B.

In one embodiment, the unit 506 to be peeled off includes at least one flexible multi-layer substrate. The at least one flexible multi-layer substrate includes at least one dielectric layer and at least one metal layer which are alternately stacked. The at least one metal layer can be selected from the group consisting of a metal wiring layer (i.e., a signal layer), a power supply layer, and a ground layer. A material of the at least one dielectric layer of the substrate can be polyimide (PI).

In another embodiment, the unit 506 to be peeled off includes at least one second flexible dielectric layer. A material of the at least one second flexible dielectric layer can be polyimide (PI).

In the multi-layer substrate structure shown in FIG. 5, when the unit 506 to be peeled off in the right portion A is required to be removed, the peel-off layer 504 is torn from a position between the peel-off layer 504 and the first flexible dielectric layer 502 to the dashed line C. Then, the peel-off layer 504 and the unit 506 to be peeled off in the right portion A are cut away along the dashed line C by a mechanical method or other methods. As such, an objective of precisely peeling off the peel-off layer 504 and the unit 506 to be peeled off in the right portion A can be achieved.

When the first flexible dielectric layer 502 in the right portion A is required to be removed, the first flexible dielectric layer 502 can be formed to be thin in advance. Then, the first flexible dielectric layer 502 is removed by a conventional dry etching method or a wet etching method.

Please refer to FIG. 6. FIG. 6 illustrates a flow chart of a method for manufacturing a multi-layer substrate structure which can be peeled off precisely in accordance with an embodiment of the present disclosure.

In step S60, a substrate is provided.

In step S62, a first flexible dielectric layer is formed on the substrate.

In step S64, a peel-off layer is formed on the first flexible dielectric layer, wherein an adhesive force between the peel-off layer and the first flexible dielectric layer is smaller than an adhesive force between the first flexible dielectric layer and the substrate.

In step S66, a unit to be peeled off is formed on the peel-off layer.

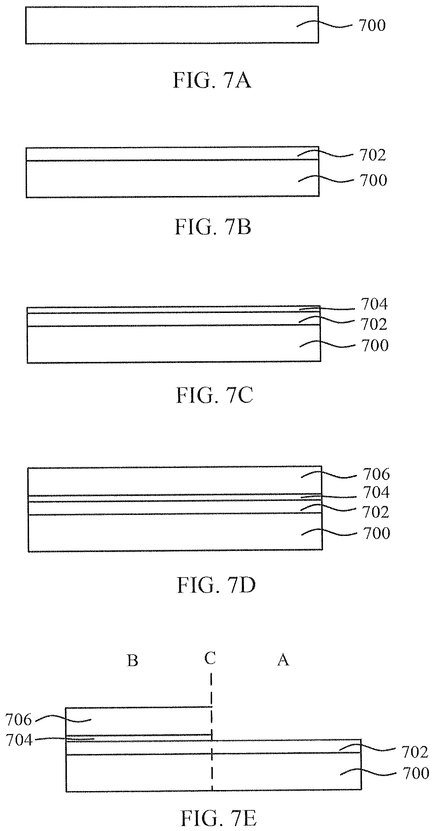

Please refer to FIG. 7A to FIG. 7E. FIG. 7A to FIG. 7E illustrate a detailed flow chart of the method for manufacturing the multi-layer substrate structure in FIG. 5.

In FIG. 7A, a substrate 700 is provided.

The substrate 700 can be a single-layer substrate or a multi-layer substrate. The substrate 700 can be selected from the group consisting of a circuit board, a glass substrate, and a ceramic substrate. A material of the substrate 700 is an organic material or an inorganic material.

The substrate 700 includes at least one dielectric layer and at least one metal layer which are alternately stacked. The at least one metal layer can be selected from the group consisting of a metal wiring layer (i.e., a signal layer), a power supply layer, and a ground layer. A material of the at least one dielectric layer of the substrate can be polyimide (PI).

In FIG. 7B, a first flexible dielectric layer 702 is formed on the substrate 700.

A material of the first flexible dielectric layer 702 can be polyimide.

In FIG. 7C, a peel-off layer 704 is formed on the first flexible dielectric layer 702.

An adhesive force between the peel-off layer 704 and the first flexible dielectric layer 702 is smaller than an adhesive force between the first flexible dielectric layer 702 and the substrate 700, so that at least one film layer on the peel-off layer 704 can be easily removed by tearing the peel-off layer 704. In detail, the at least one film layer on the peel-off layer 704 can be totally or partially and precisely removed by peeling off the peel-off layer 704.

In FIG. 7D, a unit 706 to be peeled off is formed on the peel-off layer 704.

In one embodiment, the unit 706 to be peeled off includes at least one flexible multi-layer substrate. The at least one flexible multi-layer substrate includes at least one dielectric layer and at least one metal layer which are alternately stacked. The at least one metal layer can be selected from the group consisting of a metal wiring layer (i.e., a signal layer), a power supply layer, and a ground layer. A material of the at least one dielectric layer of the substrate can be polyimide (PI).

In another embodiment, the unit 706 to be peeled off includes at least one second flexible dielectric layer. A material of the at least one second flexible dielectric layer can be polyimide (PI).

In FIG. 7E, the unit 706 to be peeled off in a right portion A is removed, and the unit 706 to be peeled off in a left portion B is reserved. A dashed line C is a dividing line between the right portion A and the left portion B.

In FIG. 7E, the peel-off layer 704 in the right portion A is torn from a position between the peel-off layer 704 and the first flexible dielectric layer 702. Then, the peel-off layer 704 and the unit 706 to be peeled off in the right portion A are cut away along the dashed line C by a mechanical method or other methods. As such, an objective of precisely peeling off the peel-off layer 704 and the unit 706 to be peeled off in the right portion A can be achieved.

When the first flexible dielectric layer 702 in the right portion A is required to be removed, the first flexible dielectric layer 702 can be formed to be thin in advance. Then, the first flexible dielectric layer 702 is removed by a conventional dry etching method or a wet etching method.

In the multi-layer substrate structure which can be peeled off precisely and the method for manufacturing the same, since the adhesive force between the peel-off layer and the first flexible dielectric layer is smaller than the adhesive force between the first flexible dielectric layer and the substrate, the at least one film layer on the peel-off layer can be totally or partially and precisely removed by peeling off the peel-off layer.

## Claims

1. A multi-layer substrate structure which can be peeled off precisely, **characterized by** comprising:
a substrate (500);
a first flexible dielectric layer (502) formed on the substrate (500);
a peel-off layer (504) formed on the first flexible dielectric layer (502); and
a unit (506) to be peeled off formed on the peel-off layer (504);
wherein an adhesive force between the peel-off layer (504) and the first flexible dielectric layer (502) is smaller than an adhesive force between the first flexible dielectric layer (502) and the substrate (500), and the substrate (500), the first flexible dielectric layer (502), the peel-off layer (504), and the unit (506) to be peeled off together form the multi-layer substrate structure.

2. The multi-layer substrate structure according to claim 1, **characterized in that** the substrate (500) is a single-layer substrate or a multi-layer substrate, the substrate (500) is selected from the group consisting of a circuit board, a glass substrate, and a ceramic substrate, and the substrate (500) comprises at least one dielectric layer and at least one metal layer which are alternately stacked.

3. The multi-layer substrate structure according to claim 2, **characterized in that** the at least one metal layer is selected from the group consisting of a metal wiring layer, a power supply layer, and a ground layer.

4. The multi-layer substrate structure according to claim 2, **characterized in that** a material of the at least one dielectric layer of the substrate (500) is polyimide.

5. The multi-layer substrate structure according to claim 1, **characterized in that** the unit (506) to be peeled off comprises at least one flexible multi-layer substrate.

6. The multi-layer substrate structure according to claim 5, **characterized in that** the at least one flexible multi-layer substrate comprises at least one dielectric layer and at least one metal layer which are alternately stacked.

7. The multi-layer substrate structure according to claim 6, **characterized in that** the at least one metal layer is selected from the group consisting of a metal wiring layer, a power supply layer, and a ground layer.

8. The multi-layer substrate structure according to claim 1, **characterized in that** the unit (506) to be peeled off comprises at least one second flexible dielectric layer.

9. The multi-layer substrate structure to claim 1, **characterized in that** a material of the first flexible dielectric layer (502) is polyimide.

10. A method for manufacturing a multi-layer substrate structure which can be peeled off precisely, **characterized by** comprising:
providing a substrate (500);
forming a first flexible dielectric layer (502) on the substrate (500);
forming a peel-off layer (504) on the first flexible dielectric layer (502), wherein an adhesive force between the peel-off layer (504) and the first flexible dielectric layer (502) is smaller than an adhesive force between the first flexible dielectric layer (502) and the substrate (500); and
forming a unit (506) to be peeled off on the peel-off layer (504).

11. The method according to claim 10, **characterized in that** the substrate (500) is selected from the group consisting of a circuit board, a glass substrate, and a ceramic substrate, the substrate (500) comprises at least one dielectric layer and at least one metal layer which are alternately stacked, the at least one metal layer is selected from the group consisting of a metal wiring layer, a power supply layer, and a ground layer, and a material of the at least one dielectric layer of the substrate (500) is polyimide.

12. The method according to claim 10, **characterized in that** the unit (506) to be peeled off comprises at least one flexible multi-layer substrate.

13. The method according to claim 12, **characterized in that** the at least one flexible multi-layer substrate comprises at least one dielectric layer and at least one metal layer which are alternately stacked.

14. The method according to claim 13, **characterized in that** the at least one metal layer is selected from the group consisting of a metal wiring layer, a power supply layer, and a ground layer.

15. The method according to claim 10, **characterized in that** the unit (506) to be peeled off comprises at least one second flexible dielectric layer.
